# EUROPEAN PATENT APPLICATION

(11) **EP 1 550 880 A1**
(43) Date of publication of application: **06.07.2005**
(21) Application number: 03807975.2
(22) Date of filing: 26.09.2003
(51) Int. Cl.: G01R 31/36

(54) **BATTERY MANAGING METOD AND DEVICE**

(30) Priority: 10.10.2002 JP 2002297994
(71) Applicant: YAMAHA HATSUDOKI KABUSHIKI KAISHA, Iwata-shi, Shizuoka 438-8501 (JP)
(72) Inventor: MATSUYAMA, Kimihisa, Yamaha Hatsudoki K. K., Iwata-shi, Shizuoka 438-8501 (JP)
(74) Representative: Grünecker, Kinkeldey, Stockmair & Schwanhäusser
(86) International application number: PCT/JP2003/012354
(87) International publication number: WO 2004/034074

(57) **Abstract**

A battery management control section 1 practices detection and calculation of a battery current and a battery voltage. Also, comparison means of the battery management control section 1 individually compares the charging current of a charger 11 calculated by a charger control section 19 and the battery current, and the charging voltage calculated by the charger control section 19 and the battery voltage. The battery management control section 1 practices calculation of a residual capacity of the electric power source 10, detection of an abnormal device condition and so forth based upon a result of the comparison between the currents and a result of the comparison between the voltages.

## Description

### Field of Technology

This invention relates to a method and a device for battery management which are applied to manage a residual capacity and the like of a battery that is mounted on an electric vehicle such as an electric bicycle as a motive power source.

### Background Technology

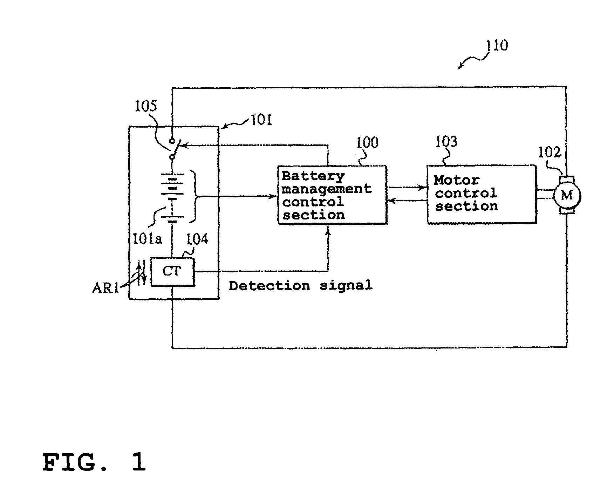

For example, a conventional battery management device 110 that is mounted on an electric bicycle incorporates a battery management control section 100 that manages an electric power source 101 that supplies operational voltage to a motor 102 for driving the electric bicycle to work as a motive power source, as shown in Fig. 1. The battery management control section 100 manages the electric power source 101, and manages the motor 102 via a motor control section 103. Also, charging/discharging currents from the electric power source 101 are detected by a current sensor (CT) 104, and a result of the detection is transferred to the battery management control section 100. Additionally, the electric power source 101 comprises a battery 101a having a plurality of battery cells and a switch 105 that is connected to the battery 101a in series.

The battery management control section 100 manages the electric power source 101 by watching the whole voltage of the battery 101a, watching individual voltages of the plurality of battery cells that form the battery 101a, and watching the detection result of the charging/discharging currents of the electric power source 101 which are detected by the current sensor 104. More specifically, the battery management control section 100 practices calculation of a residual capacity of the electric power source 101 and so forth, and, if necessary, charges the electric power source 101, controls the switch 105 connected to the battery 101a in series to open, and stops supplying the current to the motor 102 from the battery 101a.

In the conventional battery management control section 100, as shown in Fig. 1, a charging current and a discharging current of the electric power source 101 are detected by a single electric sensor 104 connected to the electric power source 101 in series, and a residual current of the electric power source 101 is calculated based upon the charging current and the discharging current that have been detected (for example, see an official gazette regarding patent application publication No. 2002-014147). Additionally, the charging current and the discharging current flow in the reverse directions relative to each other as indicated by the arrows AR1 of Fig. 1 in the proximity of the current sensor 104.

With respect to the charging/discharging currents detected by the current sensor 104, generally, the charging current is smaller than the discharging current such that the charging current is, for example, 20A whereas the discharging current is, for example, 80A. Thus, if the battery management control section 100 is designed to detect both the charging/discharging currents using the single current sensor 104 as described above, an error regarding the charging current is larger than an error regarding the discharging current. Specifically, if a discharging current of, for example, 20A is measured to be 20.1A as including an error, and also if a charging current of, for example, 7.5A is measured to be 7.6A as including an error, the errors of 0.1A are the same as each other; however, the errors are 0.1/20 and 0.1/7.5 when they are converted into a ratio, and the ratio of the error relative to the charging current is larger than the ratio of the error relative to the discharging current. That is, because, conventionally, both of the charging/discharging currents of the electric power source 101 are detected using the single current sensor 104, a problem is raised such that the precision of the detection of the charging current is inferior to the precision of the detection of the discharging current, and the resolution of the current sensor 104 also falls.

The present invention was made based upon a recognition of the above-mentioned problem, and the present invention aims to provide a method and a device for battery management that can improve the precision of the detection of a charging current and a discharging current by detecting the charging current and the discharging current using individual current detecting means, and thereby a management of the battery including calculation of a residual capacity of the battery and inhibition of deterioration of the battery can be surely made.

### Disclosure of Invention

In order to accomplish the above-mentioned object, the gist of a battery management method of the present invention is to comprise a discharging current detection step in which a discharging current from a battery is detected, a discharging current calculation step in which the detected discharging current is calculated, a charging current detection step in which a charging current to the battery is detected by a current sensor positioned on a side of a charger, a charging current calculation step in which the detected charging current is calculated, and a battery management step in which the battery is managed based upon the discharging current calculation value that has been calculated in said discharging current calculation step and the charging current calculation value that has been calculated in said charging current calculation step.

### Brief Description of the Drawings

Fig. 1 is a block diagram illustrating a structure of a conventional battery management device.
Fig. 2 is a block diagram illustrating a structure of a battery management device in accordance with an embodiment of the present invention.

### The Best Mode for Practicing Invention

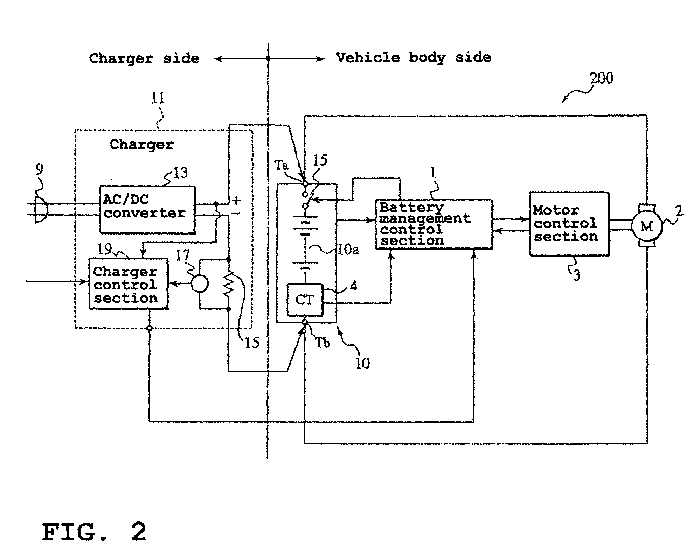

With reference to Fig. 2, the embodiment of the present invention is described below.

A battery management device 200 calculates a residual capacity of an electric power source 10 mounted on, for example, an electric bicycle as a motive power source and manages inhibition of the deterioration of the electric power source. The battery management device 200 comprises a vehicle body side that includes a battery management control section 1 for managing the electric power source 10 and a charger side that includes a charger control section 19 that is described later.

First, respective components of the vehicle body side are described.

The battery management control section 1 controls a motor 2 for driving the electric bicycle and so forth via a motor control section 3. Additionally, the electric power source 10 comprises a battery 10a that is formed by a plurality of battery cells and a switch 15 connected to the battery 10a in series.

Also, a current sensor (CT) 4 is connected to the electric power source 10 in series to be positioned between the electric power source 10 and the motor 2. The current sensor 4 precisely detects a discharging current supplied to the motor 2 from the electric power source 10, and transfers the detected discharging current to the battery management control section 1. Further, the battery management control section 1 has calculation means for practicing various calculations to calculate a voltage of the electric power source 10 and so forth based upon a value of the discharging current supplied from the electric power source 10. Furthermore, the battery management control means 1 incorporates comparison means (not shown) described below.

The comparison means compares a value of the discharging current of the electric power source 10 transferred from the current sensor 4 with a value of the charging current supplied from the charger side that is described later, and compares a value of the voltage of the electric power source 10 that has been calculated with a value of the voltage on the charger side supplied from the charger that is described later.

Also, the battery management control section 1 manages the electric power source 10 by watching the whole voltage of the electric power source 10, individual voltages of the plurality of battery cells 10a that form the electric power source 10, the value of the charging current from the current sensor 4 and the value of the discharging current from the charger. Specifically, the battery management control section 1 practices management including calculation of a residual capacity of the electric power source 10 and inhibition of the deterioration of the electric power source 10. Further, if necessary, the battery management control section 1 charges the electric power source 10, controls the switch 15 connected to the electric power source 10 in series to open, and stops supplying the current to the motor 2 from the electric power source 10.

Even though the whole voltage of the electric power source 10 is normal, if, for example, a certain battery cell 10a of the plurality of the battery cells 10a abnormally falls, the electric power source 10 can deteriorate. Thus, in order to avoid such a condition, the battery management control section 1 watches not only the whole voltage of the electric power source 10 but also the individual voltages of the respective battery cells 10a.

Next, respective components of the charger are described.

The charger 11 disposed on the charger side is connected to the electric power source 10 through terminals Ta, Tb positioned on both ends of the electric power source 10, and charges the electric power source 10 by supplying the charging current to the electric power source 10 through the terminals Ta, Tb. Additionally, the terminals Ta, Tb on both sides are not limited to those described above, and can include a switch or the like to connect/disconnect the electric power source 10 and the charger 11.

The charger 11 has an AC/DC converting power source section (AC/DC converter) 13 that rectifies the AC power supplied from an AC power source (not shown) through a plug 9 to generate a DC current that is stabilized, and supplies the DC current to the electric power source 10 as the charging current to charge the electric power source 10.

A charger control section 19 has calculation means to practice various calculations and calculate a voltage value of the charger side based on a value transferred from the plus terminal of the AC/DC converting power source section 17.

Further, a value of the charging current that is supplied to the electric power source 10 from the AC/DC converting power source section 13 of the charger 11 is transferred to the charger control section 19 through a shunt resistor 15 and a voltage meter 17 and is calculated by the charger control section 19.

In greater details, the value of the charging current supplied to the electric power source 10 from the AC/DC converting power source section 13 is created on both sides of the shunt resistor 15 as a voltage drop that is in proportion to the charging current by being supplied through the shunt resistor 15 that has a low resistance value. The voltage on both sides of the shunt resistor 15 is measured by the voltage meter 17. The voltage is transferred to the charger control section 19 and is calculated by the charger control section 19.

The voltage value and the current value calculated as described above are transferred to the comparison means of the battery management control section 1 from the charger control section 19.

Because of the above-mentioned structure, in the battery management device 200 of the present embodiment, the discharging current value of the electric power source 10 detected by the current sensor 4 and the calculated voltage value of the electric power source 10, and the current value of the charger side detected by the shunt resistor 15 and so forth and the calculated voltage value of the charger side are individually transferred to the comparison means of the battery management control section 1.

The comparison means of the battery management control section 1 compares the respective transferred values. That is, the comparison means individually conducts a comparison between the voltage value of the electric power source 10 and the voltage value of the charger 11, and a comparison between the current value of the electric power source 10 and the current value of the charger 11.

As thus described, the comparison means of the battery management control section 1 precisely detects the discharging current and the charging current, not by conducting the detection of the discharging current and the detection of the charging current using the single current sensor 104 as usual, but by conducting individually. Further, the current values of the electric power source 10 and the charger 11, and the voltage values of the electric power source 10 and the charger 11 are individually and precisely calculated and compared with each other. The battery management control section 1 can practice the battery management and can precisely calculate a residual battery capacity with high resolution based upon results of the comparisons.

Also, the battery management control section 1 can detect abnormal device conditions based upon the above-mentioned comparison results of the current values and the voltage values. The term "abnormal device conditions" means various abnormal device conditions including the poor contact and snapping of a wire.

When an abnormal device condition is detected, for example, the motor control section 3 is controlled by the battery management control section 1 to stop an operation of the motor 2, and also the switch 15 is opened by the battery management control section 1 to stop supplying the charging current to the motor 2 from the electric power source 10. Also, when a drop of the residual capacity of the electric power source 10 is detected, the electric power source 10 is charged by the charger 11, thereby deterioration of the electric power source 10 that may occur by its over discharge can be inhibited.

Additionally, the resolution is described. In the conventional method shown in Fig. 1, if the current sensor 4 for use of, for example, 100A is divided into +80A for the discharging side and -20A for the charging side to be applied for common use of charging/discharging, a conventional resolution is 100mA/bit. Meanwhile, if the shunt resistor 15 for use of, for example, 0-10A, is applied, the resolution is 10mA/bit. The precision thus can be remarkably improved.

### Possibility of Industrial Use

As described above, according to the present invention, it is characterized in that current values of the electric power source 10 and the charger 11, and voltage values of the electric power source 10 and the charger 11 are individually detected, and calculation and comparison of the current values and the voltage values are practiced based upon the detection results. Because the battery is managed based upon the comparison result, the battery management such as calculation of a residual capacity of the battery and detection of an abnormal condition of the battery can be precisely and economically practiced with high resolution. Further, deterioration of the battery and damage of the device can be avoided beforehand, and reliability can be improved.

Also, according to the present invention, the current sensor positioned on the side of the battery detects the discharging current, and thus the current sensor is not provided for charging/discharging common use. Because of this, the detection of the discharging current can be separately done from the detection of the charging current, thereby the discharging current can be precisely measured with high resolution, and further thereby the battery can be surely managed.

Further, according to the present invention, the battery can be charged at a suitable moment before the battery overly discharges, thereby the deterioration of the battery can be inhibited.

According to the present invention, an abnormal condition of the device is detected based upon a result of current comparison and a result of voltage comparison. Thus, the abnormal condition can be surely and economically detected, thereby deterioration of the battery and damage of the device can be inhibited beforehand.

## Claims

1. A method, as a battery management method, **characterized in** comprising:
a charging current detection step in which a charging current is detected by a current sensor that is positioned on a side of a charger that charges a battery;
a charging current calculation step in which the charging current is calculated from a detection result of said charging current detection step; and
a battery management step in which the battery is managed based upon a charging current calculation value that has been calculated in the charging current calculation step.

2. A method, as a battery management method, **characterized in** comprising:
a discharging current detection step in which a discharging current from a battery is detected;
a discharging current calculation step in which the discharging current is calculated from a detection result of said discharging current detection step;
a charging current detection step in which the charging current of said battery is detected by a first detector positioned on a side of a charger;
a charging current calculation step in which the charging current is calculated from a detection result of said charging current detection step; and
a battery management step in which the battery is managed based upon the discharging current calculation value that has been calculated in said discharging current calculation step and the charging current calculation value that has been calculated in said charging current calculation step.

3. The method, as the battery management method according to Claim 2, **characterized in that** in said discharging current detection step, the discharging current of said battery is detected by a second detector positioned on a side of the battery.

4. The method, as the battery management method according to Claims 2 or 3, **characterized in** further comprising a residual capacity calculation step in which a residual capacity of said battery is calculated based upon the discharging current calculation value that has been calculated in said discharging current calculation step and the charging current calculation value that has been calculated in said charging current calculation step.

5. The method, as the battery management method according to any one of Claims 2-4, **characterized in** further comprising:
a charger voltage calculation step in which a voltage of said charger is calculated;
a battery voltage calculation step in which a voltage of said battery is calculated; and
an abnormal condition detection step in which an abnormal condition is detected based upon a comparison result between the discharging current calculation value that has been calculated in said discharging current calculation step and the charging current calculation value that has been calculated in the charging current calculation step, and another comparison result between said charger voltage value and said battery voltage value.

6. The method, as the battery management method according to Claim 5, **characterized in** further that said second detector positioned on the side of said battery detects a current and a voltage of said battery.

7. Something, as a battery management device, **characterized in** comprising:
charging current detection means positioned on a side of a charger that charges a battery, and for detecting a charging current;
charging current calculation means for calculating the charging current from a detection result of said charging current detection means; and
battery management means for managing the battery based upon the charging current value that has been calculated by said charging current calculation means.

8. Something, as a battery management device, **characterized in** comprising:
discharging current detection means for detecting a discharging current from a battery;
discharging current calculation means for calculating a discharging current from a detection result of said discharging current detection means;
charging current detectionmeans positioned on a side of a charger that charges said battery, and for detecting a charging current;
charging current calculation means for calculating the charging current from a detection result of said charging current detection means; and
battery management means for managing said battery based upon the discharging current calculation value that has been calculated by said discharging current calculation means and charging current calculation value that has been calculated by said charging current calculation means.

9. Something, as a battery management device according to Claim 8, **characterized in that** said discharging current detection means has a current sensor positioned on a side of the battery, and for detecting the discharging current from said battery.

10. Something, as a battery management device according to Claim 8 or 9, **characterized in** further comprising a residual capacity calculation means for calculating a residual capacityof the battery based upon the discharging current calculation value that has been calculated by said discharging current calculation means and the charging current calculation value that has been calculated by said charging current calculation means.

11. Something, as a battery management device according to any one of Claims 8-10, **characterized in** further comprising:
charger voltage calculation means for calculating a voltage of said charger;
battery voltage calculation means for calculating a voltage of said battery; and
abnormal condition detection means for detecting an abnormal condition based upon a comparison result between the discharging current calculation value that has been calculated by said discharging current calculation means and the charging current calculation value that has been calculated by the charging current calculation means, and another comparison result between said charger voltage value and said battery voltage value.

12. Something, as a battery management device according to Claim 11, **characterized in that** said second detector positioned on the side of said battery detects the current and the voltage of said battery.
